# DEMANDE DE BREVET EUROPEEN

(11) **EP 3 182 450 A1**
(43) Date de publication de la demande: **21.06.2017**
(21) Numéro de dépôt: 16204076.0
(22) Date de dépôt: 14.12.2016
(51) Int. Cl.: H01L 23/64, H01L 23/522, H01F 17/00, H01F 27/28

(54) **DISPOSITIF D'INDUCTANCE ET SON PROCÉDÉ DE FABRICATION**

(30) Priorité: 16.12.2015 FR 1562448
(71) Demandeur: COMMISSARIAT À L'ÉNERGIE ATOMIQUE ET AUX ÉNERGIES ALTERNATIVES, 75015 Paris (FR)
(72) Inventeur: PORNIN, Jean-Louis, 38920 CROLLES (FR); PARES, Gabriel, 38190 BERNIN (FR); REIG, Bruno, 38430 MOIRANS (FR)
(74) Mandataire: Decobert, Jean-Pascal

(57) **Abrégé**

La présente invention concerne un dispositif d'inductance comprenant une bobine pourvue d'au moins une spire électriquement conductrice comprenant une première portion de spire formée sur une face d'un premier substrat (100), et une deuxième portion de spire, une première extrémité de la première portion étant reliée électriquement à une première extrémité de la deuxième portion par une liaison conductrice (310), la bobine présentant un axe longitudinal (610), autour duquel la au moins une spire est formée, qui est perpendiculaire à une dimension en épaisseur du premier substrat (100), caractérisé en ce que la deuxième portion est formée sur une face d'un deuxième substrat (200) différent du premier substrat (100), la face du premier substrat (100) étant en regard de la face du deuxième substrat (200), la liaison conductrice (310) s'étendant dans un espace interstitiel situé entre la face du premier substrat (100) et la face du deuxième substrat (200).

## Description

### DOMAINE DE L'INVENTION

La présente invention concerne en général la réalisation de composants microélectroniques et plus particulièrement de composants inductifs hybrides destinés à être utilisés au plus près de dispositifs du type de ceux produits par l'industrie de la microélectronique tels que les circuits intégrés.

### ARRIERE-PLAN TECHNOLOGIQUE

L'obtention de composants microélectroniques destinés à être utilisés avec les types de dispositifs complexes produits par l'industrie de la microélectronique tels les circuits intégrés et plus généralement les circuits incluant aussi des fonctions mécaniques et/ou optiques tels que les MEMS et/ou NEMS (de l'anglais « micro ou nano electro mechanical systems ») se heurte à de nombreuses difficultés. C'est en particulier le cas quand il s'agit d'obtenir des valeurs électriques élevées de ces composants passifs dans un espace restreint et le plus près possible de ceux-ci pour limiter les effets parasites de leur utilisation dans l'application considérée.

L'intégration complète d'un tel composant passif avec le circuit intégré l'utilisant n'apporte pas nécessairement une solution complètement satisfaisante. Un tel exemple d'intégration d'un composant inductif, c'est-à-dire une bobine ou self, est décrit par exemple dans la publication en anglais intitulée « Electro-Magnetic Modeling and Design of Through Silicon Vias Based Passive Interposers for High Performance Applications up to the V-Band » publiée en 2012 dans « International Journal on Advances in Systems and Measurements, vol 5 no 1 & 2 » par Olivier Tesson et ses coauteurs. Ceux-ci y décrivent un composant inductif qui utilise le substrat du circuit intégré comme couche isolante pour définir la hauteur des spires de la bobine. Des traces métalliques qui constituent en partie les spires de la bobine sont définies de part et d'autre du substrat, les interconnexions pour relier les traces métalliques entre elles et former une bobine sont assurées par des vias traversants dits TSV acronyme de l'anglais « Through Silicon Vias ».

Dans ce cas, une des limitations va être le rapport de forme ou « aspect ratio » en anglais, c'est-à-dire le rapport diamètre sur profondeur des vias traversants qui va soit limiter l'épaisseur du substrat, soit imposer un espace important entre deux spires voisines. Il sera également difficile d'intégrer un matériau magnétique dans les spires.

On connait en outre des bobines dont les spires ont un axe dirigé selon l'épaisseur du substrat comme dans le document brevet JP A 2001 077538 qui montre un empilement de substrats chacun doté en surface d'une spire, l'empilement des substrats formant une bobine dont l'enroulement est orienté selon la hauteur de l'empilement.

C'est donc un objet de l'invention que de pallier au moins en partie les inconvénients des techniques actuelles de réalisation de composants passifs, et en particulier de composants inductifs comme illustré dans la publication ci-dessus, en décrivant un procédé qui n'apporte aucune contrainte au circuit intégré devant les utiliser. C'est en particulier un objet de l'invention que la valeur de l'inductance puisse être ajustée sans aucun inconvénient pour le circuit intégré tout en maintenant un niveau d'intégration similaire à celui qui serait obtenu avec une intégration complète du composant passif.

### RESUME DE L'INVENTION

Un aspect de la présente invention concerne un composant microélectronique comprenant une bobine pourvue d'au moins une spire électriquement conductrice comprenant une première portion de spire formée sur 'un premier substrat, et une deuxième portion de spire, une première extrémité de la première portion étant reliée électriquement à une première extrémité de la deuxième portion par une liaison conductrice, la bobine présentant un axe longitudinal, autour duquel la au moins une spire est formée, qui est perpendiculaire à une direction selon une épaisseur du premier substrat.

Avantageusement, la deuxième portion est formée sur un deuxième substrat différent du premier substrat, une première face du premier substrat étant en regard d'une première face du deuxième substrat, la liaison conductrice s'étendant au moins dans un espace interstitiel situé entre la première face du premier substrat et la première face du deuxième substrat.

Ainsi, les deux portions de spire sont réalisables séparément en surface de deux substrats. Ces derniers peuvent être de natures différentes. En outre, les liaisons conductrices entre les portions de spire sont aménagées dans l'espace entre les deux substrats. Cet espace peut être choisi dans une large gamme d'épaisseur et les liaisons conductrices choisies en conséquence. De la sorte, l'inductance du dispositif, qui est fonction de la hauteur des liaisons en question car elles participent à la bobine, est aisément ajustable et peut prendre une valeur très différente d'un dispositif à un autre.

Des valeurs d'inductance élevées peuvent être atteintes car l'invention n'est plus contrainte aux limites de fabrication de liaisons telles des vias. On peut remplir l'espace avec un matériau magnétique destiné à augmenter la valeur de l'inductance.

La présente invention concerne également, dans des modes de réalisation, un procédé de fabrication d'un composant inductif comprenant une bobine pourvue d'au moins une spire électriquement conductrice, comprenant :
- la formation d'une première portion de spire sur un premier substrat, et la formation d'une deuxième portion de spire, la bobine présentant un axe longitudinal, autour duquel la au moins une spire est formée, qui est perpendiculaire à une direction selon une épaisseur du premier substrat ;
- le raccordement électrique d'une première extrémité de la première portion à une première extrémité de la deuxième portion par une liaison conductrice.

Avantageusement, la formation de la deuxième portion est réalisée sur un deuxième substrat différent du premier substrat, une première face du premier substrat étant placée en regard d'une première face du deuxième substrat, la liaison conductrice s'étendant dans un espace interstitiel situé entre la première face du premier substrat et la première face du deuxième substrat.

Un autre aspect de modes de réalisation de l'invention est relatif à un système électronique comprenant au moins un composant inductif comme décrit précédemment.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- La FIGURE 1 illustre les portions de spire du composant inductif de l'invention qui ont été réalisées sur un premier substrat.
- La FIGURE 2 illustre les portions de spire du composant inductif de l'invention qui ont été réalisées sur un deuxième substrat.
- La FIGURE 3 est une vue en plan du deuxième substrat après réalisation sur celui-ci des liaisons conductrices entre premier et deuxième substrats.
- La FIGURE 4 est une vue en coupe du deuxième substrat après réalisation sur celui-ci des liaisons conductrices entre premier et deuxième substrat.
- La FIGURE 5 est une vue en coupe des premier et deuxième substrats après assemblage.
- La FIGURE 6 est une vue en plan d'un composant inductif selon l'invention après assemblage des substrats.
- La FIGURE 7 est une vue en coupe des premier et deuxième substrats assemblés et remplissage de l'espace interstitiel avec un élément magnétique destiné à augmenter la valeur de l'inductance.
- La FIGURE 8 illustre les étapes du procédé de réalisation d'un élément inductif de l'invention.
- La FIGURE 9 illustre une première variante de l'invention dans laquelle la partie inférieure de la bobine est réalisée sur la face inférieure du premier substrat.
- La FIGURE 10 illustre une deuxième variante de l'invention dans laquelle la partie supérieure de la bobine est réalisée sur la face supérieure du deuxième substrat.
- La FIGURE 11 illustre une combinaison de la première variante et de la deuxième variante de l'invention décrites dans les figures 9 et 10.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- la première portion est formée sur la première face du premier substrat ou sur une deuxième face du premier substrat opposée à la première face et/ou la deuxième portion est formée sur la première face du deuxième substrat ou sur une deuxième face du deuxième substrat opposée à la première face ;
- la liaison conductrice comprend une portion qui s'étend dans l'espace interstitiel et comprend une portion s'étendant dans au moins l'un des premier et deuxième substrats ;
- la portion de la liaison conductrice s'étendant dans au moins l'un des premier et second substrats comprend au moins un via conducteur traversant ledit au moins l'un des premier et second substrats ;
- Il comporte au moins un substrat intercalé entre le premier substrat et le deuxième substrat, la liaison conductrice comprenant une portion s'étendant au travers du au moins un substrat intercalé ;
- La portion de la liaison conductrice s'étendant au travers du au moins un substrat intercalé comprend au moins un via conducteur traversant ledit au moins un substrat intercalé ;
- la liaison conductrice est configurée pour produire un assemblage mécanique des première et deuxième portions ;
- la liaison conductrice comprend au moins l'un parmi les éléments suivants : une couche électriquement conductrice, un micro-tube ou un micropillier électriquement conducteur, une bille électriquement conductrice, une pâte ou un film conducteur anisotrope ;
- la liaison a une dimension non nulle, suivant la direction en épaisseur du premier substrat ;
- la liaison conductrice comprend une zone en continuité électrique de la première extrémité de la première portion, une zone en continuité électrique de la première extrémité de la deuxième portion, lesdites zones étant assemblées, de préférence par collage direct avec ou sans thermocompression ; ces zones peuvent être chacune dans le plan d'une des portions de spire, si bien que l'assemblage s'opère sans espace important entre les faces des substrats. Ces zones peuvent aussi être dans l'épaisseur de la liaison conductrice, par exemple entre les substrats intercalés faisant notamment l'objet d'un collage direct entre eux. Ces zones assemblées s'entendent donc de tout raccordement ente deux parties de la liaison conductrice entre portions de spire, de préférence par collage direct, sans apport de matière, par adhésion moléculaire.
- le dispositif comprend un élément magnétique placé dans l'espace interstitiel au moins dans une zone dudit espace située dans la au moins une spire ;
- au moins l'un parmi le premier et le deuxième substrat comporte une couche électriquement conductrice surmontée par une couche superficielle diélectrique ladite couche conductrice comprenant la portion de spire correspondante;
- la portion de spire formée sur au moins l'un parmi le premier substrat et le deuxième substrat est une piste conductrice ;
- les matériaux du premier substrat et du deuxième substrat, au niveau de leur première face, sont différents. ;
- la bobine comprend une pluralité de spires, deux spires successives de la pluralité de spires étant reliées électriquement par une liaison conductrice entre une deuxième extrémité d'une première portion d'une des deux spires successives et une deuxième extrémité d'une deuxième portion de l'autre des deux spires successives.

On forme un système comprenant une pluralité de composants inductifs ayant le même premier substrat et des deuxièmes substrats différents.

On assemble mécaniquement les première et deuxième portions en même temps que le raccordement électrique, au moyen de la liaison conductrice ;
- la liaison conductrice est formée avec au moins l'un parmi les éléments conducteurs suivants : une couche électriquement conductrice, un micro-tube électriquement conducteur, une bille électriquement conductrice, une pâte ou un film conducteur anisotrope ;
- sur au moins l'une parmi la première et la deuxième portion, on effectue :
   - le dépôt d'une couche diélectrique ;
   - la formation d'une ouverture dans la couche diélectrique, au droit de la première extrémité ;
   - la formation de l'élément conducteur au contact de ladite une parmi la première et la deuxième portion, au travers de l'ouverture.

La formation de l'élément conducteur comprend le dépôt d'au moins une couche électriquement conductrice sur la ladite une parmi la première et la deuxième portion au travers de l'ouverture, et le dépôt d'une bille fusible sur la couche électriquement conductrice. Cette au moins une couche peut servir à la liaison mécanique à produire. En particulier, les liaisons du type bille (telle que UBM ici notamment décrite) permettent d'assumer une cohésion mécaniquement stable.
- On opère une fusion de la bille fusible ou d'un autre élément conducteur pendant l'assemblage des portions ;
- la liaison conductrice est formée par collage direct avec ou sans thermocompression configuré pour assembler une zone en continuité électrique de la première extrémité de la première portion et une zone en continuité électrique de la première extrémité de la deuxième portion.
- On opère l'intégration d'un élément magnétique dans l'espace interstitiel, au moins dans une zone dudit espace située dans la au moins une spire.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

Il est précisé que dans le cadre de la présente invention, que l'épaisseur d'une couche se mesure selon une direction perpendiculaire à la surface selon laquelle cette couche présente son extension maximale.

Un aspect de l'invention est lié à la formation de portions de spire, avantageusement sous forme de traces ou pistes conductrices. D'une manière générale, tout ou partie de ces portions peuvent être formées sur un au moins des substrats. Le terme « sur » signifie que les portions sont portées par le substrat en question.

Ce peut être non exclusivement sur une face, c'est-à-dire au niveau d'une parmi la première et la deuxième face d'un des substrats. Cela ne signifie pas que lesdites portions sont obligatoirement finalement apparentes, en exposition vers l'extérieur, au niveau de l'un ou l'autre des substrats. Par exemple, des couches supplémentaires peuvent recouvrir les portions de spire après leur fabrication.

Selon l'invention, on entend par dispositif microélectronique, un dispositif comportant des éléments de dimensions micrométriques et/ou nanométriques. Il en va de même du terme « composant électronique » éventuellement ici employé. Tout système ayant pour son fonctionnement au moins un élément électrique entre dans le cadre de l'invention. Ce dispositif microélectronique peut être un MEMS ayant par exemple une fonction mécanique et/ou optique et/ou photonique et/ou électrique.

Les dessins, et la description qui suit, se concentrent par simplicité sur la formation d'un seul composant inductif mais il est entendu que plusieurs composants peuvent être fabriqués simultanément ou successivement sur un même support ou substrat, par exemple par préhension et placement d'une pluralité de deuxièmes substrats, par une technique telle que le flip chip (report par accostage de puces).

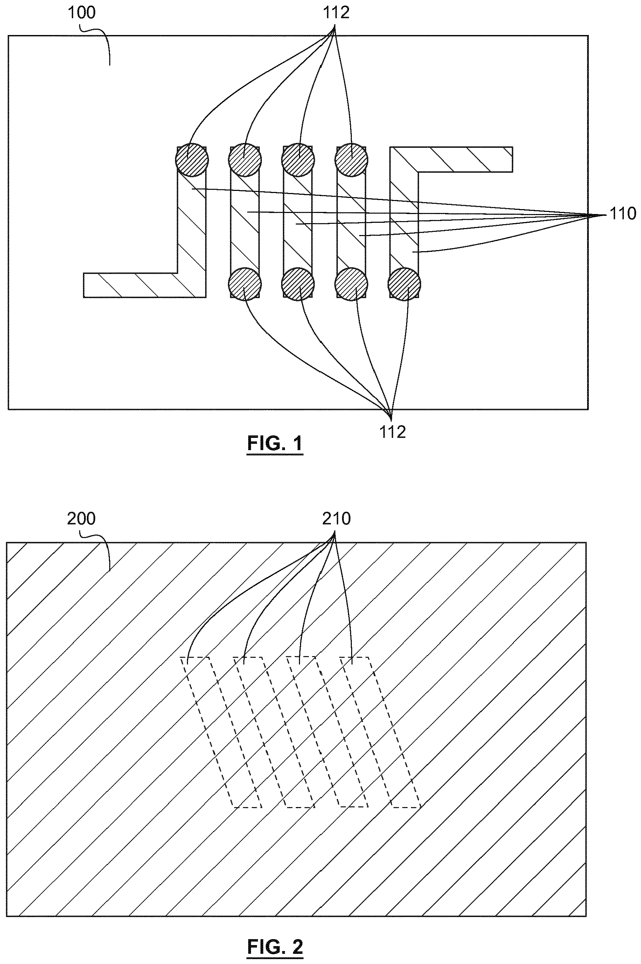

La **figure 1** montre schématiquement, en vue de dessus, un premier support ou substrat 100 à partir duquel on va pouvoir réaliser un composant inductif selon l'invention. Ce premier support est typiquement un substrat du type de ceux communément utilisés par l'industrie de la microélectronique pour produire toutes sortes de dispositifs comprenant au moins une partie électrique comme déjà mentionné ci-dessus. Dans le cadre de l'invention on entend donc préférentiellement par support, un substrat le plus souvent fait à partir de silicium, appelé plaque mais aussi fréquemment désigné du terme anglais « wafer ». Une plaque pourra être initialement typiquement faite de silicium massif ou constituer un produit déjà élaboré de type SOI, c'est-à-dire silicium sur isolant. Le substrat peut aussi, par exemple, être en verre. De façon générale, le support peut comporter plusieurs couches incluant au moins une couche semi-conductrice et au moins une couche isolante. À l'issue des étapes de fabrication le substrat est possiblement découpé en puces individuelles, chacune constituant un des dispositifs à réaliser.

La figure 1 est une vue en plan du support 100 contenant un tel dispositif individuel sur lequel on va aussi réaliser de façon hybride, comme décrit ci-après, au moins un composant inductif selon l'invention.

Le premier support ou substrat 100 est, par exemple, un circuit intégré (CI) réalisé de façon conventionnelle avec les procédés développés par l'industrie de la microélectronique qui, dans l'application considérée, requiert l'utilisation d'un composant inductif pour son fonctionnement. Le premier support peut également être un interposeur comportant des CI fabriqués de façon indépendante et reportés ensuite par différentes techniques telles que le collage ou la soudure en « flip chip ».

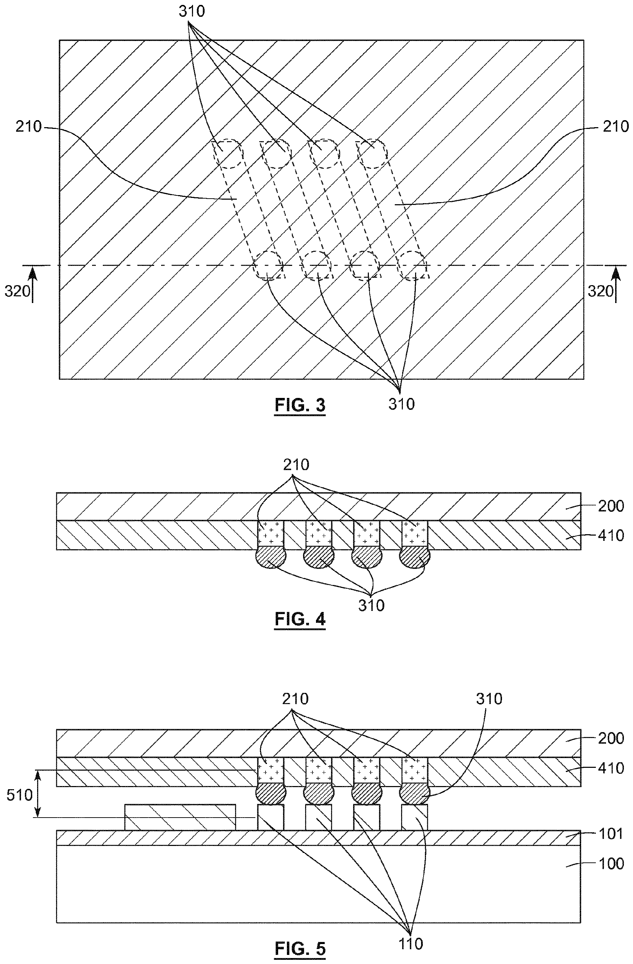

Avantageusement, ce composant passif doit pouvoir être placé au plus près du CI et réalisé au cours d'un même cycle d'étapes de fabrication ce que permet l'invention. De façon standard les composants électroniques d'un circuit intégré, typiquement des transistors à effet de champ (FET), y sont interconnectés à l'aide de nombreuses couches de métallisation planes isolées les unes des autres et situées au-dessus de ces composants. La face supérieure du substrat 100 peut être formée par la surface exposée d'une couche 101 de nature électriquement isolante. Si la couche sous-jacente est en silicium, la couche 101 (par exemple visible en figure 5) peut être en SiO2.

La première étape de l'invention consiste à réaliser, avantageusement en même temps que la dernière couche d'interconnexions métalliques, c'est-à-dire celle située le plus en surface dans l'empilement des couches constituant le circuit intégré, les traces métalliques 110 qui vont constituer une première portion des spires d'un composant inductif selon l'invention. Optionnellement, les traces métalliques 110 pourront cependant être faites après que la dernière couche du circuit intégré aura été réalisée.

On remarquera ici qu'un composant inductif selon l'invention pourra, en fonction des applications, aussi bien être réalisé en partant de n'importe quel type de support 100 permettant le dépôt d'une couche conductrice permettant la réalisation à sa surface, de façon standard par photolithographie et gravure, des traces métalliques 110. Il pourra s'agir notamment de traces métalliques sur un substrat en verre.

On a illustré au repère 112 des zones d'extrémité des traces 110 au niveau desquelles des liaisons électriques pourront mettre en continuité les traces 110 avec les traces d'un deuxième substrat décrit ci-après.

La **figure 2** est une vue en plan d'un deuxième substrat 200 sur lequel on réalise une deuxième portion des spires d'un composant inductif selon l'invention, là aussi sous la forme de traces métalliques 210 dont les motifs sont adaptés pour permettre, comme on va le voir ci-après, leur interconnexion avec les traces 110 du premier substrat afin de former in fine une bobine électriquement continue formant un composant inductif selon l'invention. On notera que les traces 210 sont ici représentées comme ayant été réalisées sur la face cachée du deuxième substrat après retournement de celui-ci. Comme dans le cas du premier substrat, le deuxième substrat peut comporter également des circuits intégrés (CI).

Le deuxième substrat pourra être fait de silicium, de verre et de tout autre matériau adapté à la réalisation de traces conductrices sur une au moins de ses surfaces.

Dans le cas des figures 2 à 4, le substrat 200 comporte une face inférieure, en vis-à-vis de la face supérieure du substrat 100, qui est la surface exposée d'une couche isolante. Dans cette situation, par exemple avec un support en verre, il n'y a pas nécessité de dépôt d'une couche superficielle isolante.

On notera que les pistes ou traces conductrices des premier et deuxième substrats sont possiblement constituées sans inconvénients d'un même matériau conducteur, le plus généralement un métal couramment utilisé par l'industrie de la microélectronique comme l'aluminium ou le cuivre, ou de matériaux différents.

Les portions de spire, sous forme de traces du premier substrat 100, sont représentées sous forme de bandes parallèles avantageusement de longueur et/ou de largeur identiques. Ces bandes sont espacées suivant une direction définissant l'axe longitudinal de la bobine. Dans l'exemple, deux bandes d'extrémité comportent chacune une connexion avec une trace de raccordement de la bobine.

Les traces du deuxième substrat 200 sont configurées pour être complémentaires de celle du premier substrat 100, de sorte à permettre à terme la formation d'un enchaînement continu alternant portions 110 et portions 210, sont ici également parallèles entre elles, de même largeur et longueur, et inclinées relativement aux portions 110.

Cette inclinaison permet de placer une première extrémité d'une portion 210 au droit d'une première extrémité de portion 110, et une deuxième extrémité de ladite portion 210 au droit d'une deuxième extrémité d'une autre portion 110.

C'est au niveau de ces extrémités que l'on peut opérer la liaison électrique entre les portions de spire.

A titre de remarque, le terme « spire » s'entend ici selon une part de bobine s'étendant en boucle ouverte, les extrémités de la boucle étant espacées suivant l'axe longitudinal de la bobine, et étant dans un même plan parallèle au dit axe. C'est donc une partie élémentaire de la bobine. Au moins une spire est formée. D'une manière générale, on s'arrange pour que la surface sur laquelle reposent les traces des portions 110, 210, ne soient pas électriquement conductrices, pour prévenir les courts-circuits. C'est donc le cas de la couche superficielle du substrat 200 en figures 4 et 5 et de la couche 101 en figure 5. Toute configuration d'empilement de couches et de choix de matériaux de couche des substrats 100, 200 permettant cette isolation est susceptible de convenir.

La **figure 3** est une vue en plan du deuxième substrat (après retournement de celui-ci) sur lequel on a réalisé dans cet exemple le système d'interconnexion des deux substrats. On remarquera ici que le système d'interconnexion des deux substrats qui va, après assemblage de ces derniers, permettre de former un composant inductif selon l'invention, est possiblement préparé sur l'un ou l'autre des deux substrats ou, conjointement, sur les deux substrats séparément.

Dans l'exemple de la figure 3 le système permettant l'interconnexion des deux substrats est préparé sur le deuxième substrat seul sous la forme de billes ou de plots 310 destinés à assurer une liaison conductrice entre chacune des portions de spire des premier et deuxième substrats. Les billes ou plots sont réalisés en utilisant des procédés bien connus mis en oeuvre de façon courante par l'industrie de la microélectronique. Notamment, on sait réaliser aux extrémités des portions de spire 210 des billes faites d'un alliage étain-argent (SnAg) ou des plots de cuivre (Cu) comme ceux utilisés pour les interconnexions tridimensionnelles (3D) en microélectronique.

La **figure 4** est une vue en coupe 320 du deuxième substrat 200 après que les liaisons conductrices (par exemple billes ou plots) 310 entre les deux substrats ont été préparés, dans cet exemple, aux extrémités des portions de spire 210 du deuxième substrat. Comme représenté sur cette figure, les portions de spire 210 sont noyées dans un matériau isolant 410 avant réalisation des liaisons conductrices 310.

La **figure 5** montre, en coupe, le composant inductif obtenu après retournement et positionnement du deuxième substrat 200 et assemblage de ce dernier sur le premier substrat 100. Le procédé utilisé est dit « flip chip » ou « retournement de puce » est bien connu et largement utilisé par toute l'industrie de la microélectronique. La figure 5 illustre le cas d'une interconnexion à la fois mécanique et électrique des premier et deuxième substrats qui se fait plus particulièrement en mettant en oeuvre une méthode bien connue dite de « solder reflow » c'est-à-dire de refusion des billes 310, notamment celles de SnAg mentionnées ci-dessus, afin d'établir une bonne liaison électrique entre les portions de spire des premier et deuxième substrats, 110 et 210.

Toutes les méthodes d'interconnexions utilisées de façon standard par l'industrie de la microélectronique sont susceptibles d'être employées pour permettre l'assemblage et l'interconnexion électrique des deux substrats. Les méthodes qui peuvent être utilisées sont entre autres : le collage direct, la thermocompression, les micro-tubes ou les films conducteurs anisotropes (ACF). Suivant le type d'interconnexion des substrats choisi on obtiendra des hauteurs 510 et des sections très différentes du composant inductif ainsi réalisé qui vont grandement conditionner la valeur électrique de l'inductance. Ces hauteurs peuvent être comprises dans une gamme de valeurs inférieures au micron (10⁻⁶ mètre) dans la méthode par collage direct, jusqu'à quelques dizaines de microns voire plus dans le cas illustré par la figure 5 de refusion de billes, par exemple de SnAg.

On notera sur la figure 5 la présence d'une couche de passivation 101 sur le premier substrat.

La liaison conductrice 310 peut aussi s'étendre au travers d'un ou plusieurs substrats intercalés entre le premier substrat 100 et le deuxième substrat 200. Plus précisément, la première face du premier substrat et la première face du deuxième substrat ne sont pas dans ce cas simplement espacées l'une de l'autre ; l'espace intercalaire entre-elles est aussi ici le lieu de présence d'au moins un substrat intercalé. L'épaisseur de ce substrat est de préférence orientée selon la même direction que celle des substrats 100, 200. Il comporte une zone traversant de part en part son épaisseur et permettant la continuité électrique avec le reste de la liaison conductrice 310. Le corps de ce substrat intercalé peut être à base d'un matériau conducteur, tel du silicium. La technique des vias peut être employée pour former ces portions s'étendant dans l'épaisseur du substrat intercalé.

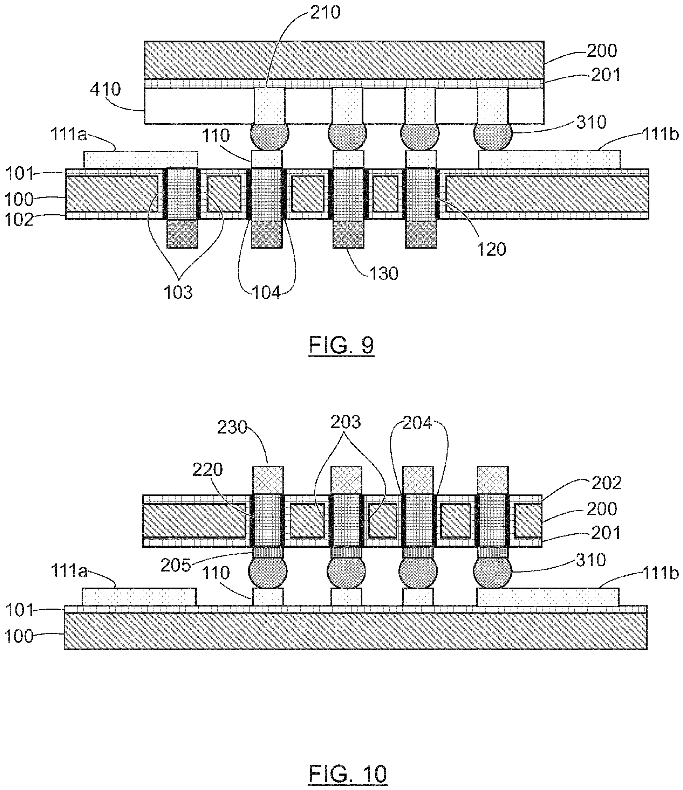

On peut empiler plusieurs substrats intercalés et relier leurs portions conductrices participant aux liaisons 310. Ce raccordement de substrats peut se faire suivant toutes techniques dont celles décrites pour un raccordement direct du premier et du deuxième substrat 100, 200 en référence aux figures notamment. A propos des vias, la description des figures 9 à 11 donne des possibilités de réalisation qui peuvent être adaptées aux substrats intercalés.

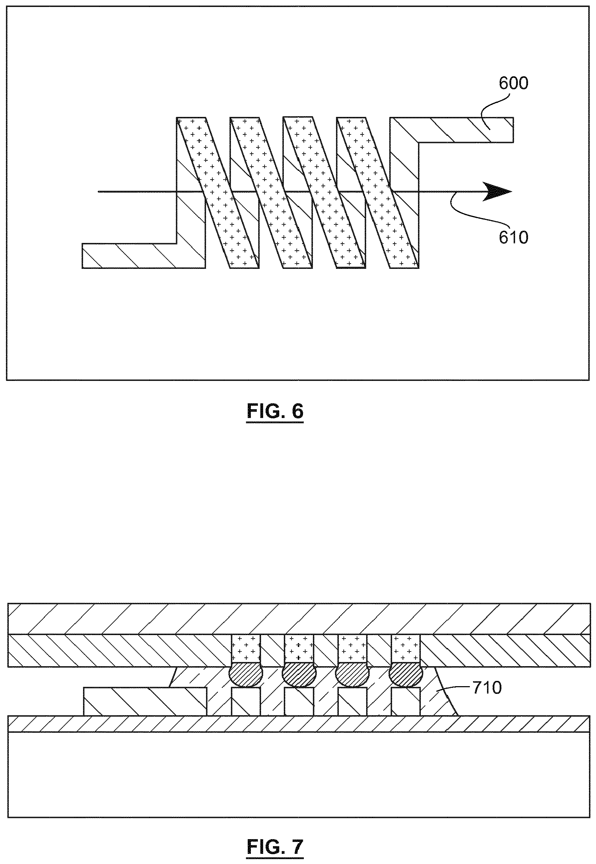

La **figure 6** montre une vue en plan d'un composant inductif 600 selon l'invention qui correspond à la vue en coupe de la figure 5. L'axe électrique du composant est celui représenté 610. Il est parallèle au plan des substrats assemblés 100 et 200.

La **figure 7** illustre, sous la forme d'une vue en coupe similaire à celle de la figure 5, la possibilité offerte par l'invention de remplir l'espace interstitiel entre les deux substrats par un élément magnétique 710 destiné à augmenter la valeur de l'inductance obtenue. Cette augmentation est directement proportionnelle à la valeur de la constante magnétique du matériau utilisé pour le remplissage. Pour ce faire on procède soit à un remplissage à l'aide d'un liquide de type résine polymère chargée de particules magnétiques, soit on insère un matériau ayant des propriétés équivalentes couramment disponible sous forme de films minces ou de fils.

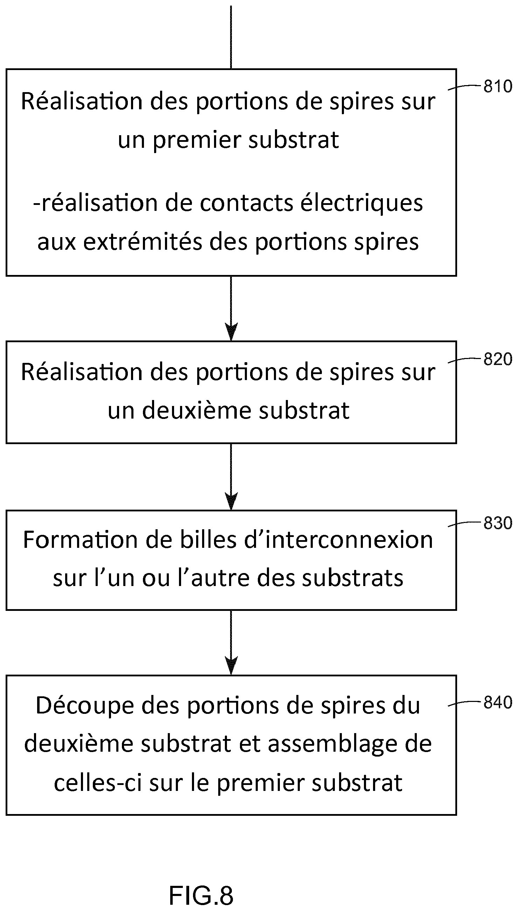

La **figure 8** résume les étapes du procédé qui permet d'obtenir un composant inductif selon l'invention.

Dans une première étape 810, on réalise par photolithographie et gravure les portions de spire 110 du premier substrat 100. Avantageusement, elles sont faites simultanément à la réalisation du dernier niveau de métallisation et d'interconnexions du circuit intégré utilisant le composant inductif de l'invention 600. Le circuit intégré servant de support 100 est typiquement un circuit dit CMOS, la technologie la plus largement utilisée actuellement qui emploie des transistors FET de structure métal oxyde semi-conducteur (MOS) complémentaires (C) c'est-à-dire utilisant simultanément des transistors des deux types de conduction : à canal N et à canal P. Avantageusement, les portions de spire 110 sont ainsi réalisées en cuivre, couramment utilisé pour réaliser les interconnexions de ces circuits intégrés. Typiquement, elles sont d'une épaisseur de 3 microns. On notera que de façon standard la dernière couche d'interconnexions métalliques, et donc les portions de spire 110, sont alors comprises dans un sandwich de couches d'oxyde (non représentées) assurant leur isolation électrique.

Comme montré sur la figure 1, on réalise également au cours de cette étape des surfaces « mouillables » aux extrémités des portions de pistes 110 c'est-à-dire qu'on pratique par photolithographie et gravure de la couche d'oxyde supérieure (non représentée) qui est typiquement de l'oxyde de silicium (SiO2) d'une épaisseur de 1 micron, des ouvertures 112 permettant d'établir un contact électrique avec les portions de spire 110. La taille des ouvertures 112 dépend de la technique retenue pour l'interconnexion des premier et deuxième substrats. Elle sera par exemple adaptée à la taille des billes d'interconnexion utilisées. Dans ce cas, on pourra aussi avoir à pratiquer une métallisation standard de ces ouvertures dite UBM, acronyme de l'anglais « under bump metallisation » destinée à obtenir à la fois, à l'issue de la soudure par refusion, une bonne tenue mécanique et un excellent contact électrique du système d'interconnexions par billes.

Dans une deuxième étape 820, on réalise sur un deuxième substrat 200 les autres portions de spire. Cette étape inclut le dépôt d'une couche isolante (non représentée) si le substrat 200 est une plaque par exemple faite de silicium ou d'un autre matériau conducteur. On peut ensuite pratiquer un dépôt, par exemple en phase vapeur, d'une couche conductrice de cuivre sur une épaisseur, par exemple de l'ordre de 3 microns. Les portions de spire 210 du deuxième substrat sont ensuite réalisées comme à l'étape précédente par photolithographie et gravure de la couche de cuivre qui vient d'être déposée.

Alternativement pour former les premières et/ou les deuxièmes portions conductrices, on peut effectuer une croissance électrolytique d'une couche de cuivre d'une épaisseur, par exemple de l'ordre de 3 microns à partir d'une couche de germination préalablement déposée sur un fond continu conducteur encore appelée du terme anglais de « seed layer » et sélectivement préservée selon les portions à réaliser.

Dans une troisième étape 830, on prépare l'interconnexion des premier et deuxième substrats, par exemple sous la forme d'un dépôt d'un matériau fusible comme l'alliage étain-argent (SnAg) déjà mentionné précédemment, afin de former par refusion des billes de ce matériau sur l'un ou l'autre des substrats. Les billes ainsi formées sont typiquement d'un diamètre de 50 microns.

À l'étape suivante 840, on procède d'abord le cas échéant à une découpe du deuxième substrat de façon à obtenir autant d'éléments discrets qu'il y a de portions de spire 210 qui ont été réalisées sur ce deuxième substrat 200. On peut alors procéder successivement, après alignement, à un assemblage de chacun des éléments discrets ainsi obtenus sur les emplacements correspondants du premier substrat. Comme déjà décrit l'assemblage et l'interconnexion des substrats se fait par la technique dite « flip chip » c'est-à-dire par retournement des éléments discrets provenant du deuxième substrat et refusion des billes d'interconnexion ci-dessus.

On remarquera ici que la valeur d'un composant inductif est directement proportionnelle à la section de la bobine qui la constitue. Lorsque ce composant inductif est réalisé entièrement sur un circuit intégré, par exemple en formant les spires pour moitié sur une couche isolante et pour moitié sous la même couche isolante, puis en réalisant les interconnexions entre les moitiés de spires au travers de cette couche isolante, la section rectangulaire de la bobine est approximée comme étant égale à la longueur des demi spires, multipliée par la faible épaisseur de la couche isolante. Dans le seul but d'augmenter la valeur de l'inductance il est difficile d'augmenter l'épaisseur de l'isolant sans inconvénients pour le procédé, par exemple de type CMOS, qui sert en même temps à réaliser le circuit intégré. Déposer des couches épaisses de plusieurs microns, voire de quelques dizaines de microns, peut générer un stress du substrat sur lequel le circuit intégré est réalisé. Par ailleurs, la gravure de cette couche pourra s'avérer être une opération longue et coûteuse les procédés standards étant limités à une dizaine de microns actuellement.

L'invention propose donc un moyen d'augmenter la valeur de l'inductance sans les inconvénients ci-dessus. L'accroissement de la section de la bobine est obtenu comme on l'a vu en augmentant la distance entre les portions de spire dans un plan perpendiculaire à l'axe de celle-ci. La bobine est ainsi composée de trois éléments assemblés : des traces métalliques correspondant à des portions de spire réalisées indépendamment sur deux substrats distincts, l'un pouvant avantageusement être le circuit intégré utilisant le composant inductif. Les deux substrats sont ensuite assemblés face à face et interconnectés à l'aide d'un troisième élément tel que des billes d'interconnexion qui ferment les spires de la bobine au cours de l'assemblage permettant ainsi d'obtenir une section importante et donc une valeur d'inductance élevée sans inconvénients pour le circuit intégré.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif, dont ceux expliqués plus en détail ci-dessous.

La **figure 9** présente une variante de l'invention dans laquelle les traces ou pistes conductrices 130 du premier substrat constituant la partie inférieure de la bobine sont dans ce cas réalisées sur la face inférieure (ou deuxième face) du substrat 100, c'est-à-dire sur la face opposée à la première face en vis-à-vis de la face inférieure (ou première face) du substrat 200. La connexion électrique entre ces traces et donc la liaison conductrice entre les deux substrats est alors constituée au moins par des vias 120 traversant le premier substrat et par un conducteur 110 disposé sur la face supérieure de celui-ci. L'entrée et la sortie de la bobine sont réalisées avantageusement sur la face supérieure du premier substrat au niveau des éléments 111 a et 111 b formés simultanément avec les pistes conductrices 110. Afin d'obtenir un nombre entier de spires, l'entrée de la bobine 111a est possiblement reliée à un via traversant le premier substrat tandis que la sortie 111 b est reliée à un élément de connexion entre les deux substrats.

On remarquera ici que pour assurer l'isolation électrique des spires de la bobine le premier substrat 100 comprend de préférence, à moins qu'il ne soit fait lui-même d'un matériau isolant, deux couches diélectrique, 101 et 102, qui vont permettre d'isoler électriquement les conducteurs de type 110 et 111 disposés sur la face supérieure ainsi que les pistes conductrices 130 sur la face inférieure en dehors des zones de vias figurant sur la vue en coupe de la bobine représentée sur la figure 9. Typiquement, le premier substrat est fait de silicium et les couches diélectriques, 101 et 102, sont constituées d'oxyde de silicium (SiO2). On notera également que les vias 120 sont de façon conventionnelle isolés électriquement du substrat par une couche diélectrique 103. Dans le cas de l'utilisation d'un matériau métallique comme le cuivre pour leur réalisation on trouvera aussi de façon classique une couche barrière 104 destinée à empêcher la diffusion de ce matériau dans le substrat. Si du cuivre est utilisé pour les autres connections électriques, l'emploi d'une couche barrière (non représentée) pourra s'avérer nécessaire.

Le deuxième substrat 200 reste identique à ce qui a été décrit avec la figure 4. On notera la présence optionnelle d'une couche diélectrique 201, déjà mentionnée, qui est nécessaire dans le cas où le deuxième substrat n'est pas constitué d'un matériau isolant. Optionnellement, comme déjà décrit dans la figure 4, les pistes 210 pourront elles-mêmes être comprises dans une couche isolante 410.

La **figure 10** présente une autre variante de l'invention dans laquelle les traces ou pistes conductrices 230 du deuxième substrat, constituant la partie supérieure de la bobine, sont dans ce cas réalisées sur la face supérieure du substrat 200, c'est-à-dire sur la face opposée à la face en vis-à-vis de la face inférieure du substrat 100. La connexion électrique entre ces pistes conductrices et la liaison conductrice entre les deux substrats est constituée au moins par des vias 220 traversant le deuxième substrat et par un conducteur 205 disposé sur la face inférieure de celui-ci. Le premier substrat reste alors identique à ce qui a été décrit dans les figures 1 et 5. De façon similaire à ce qui a été décrit dans la figure précédente on notera la présence des couches diélectriques 201, 202 et 203 qui assurent l'isolation électrique des différents éléments conducteurs constituant la bobine. Dans le cas de l'utilisation de cuivre on notera également l'emploi d'une couche barrière seulement représentée dans cette figure au niveau des vias 220.

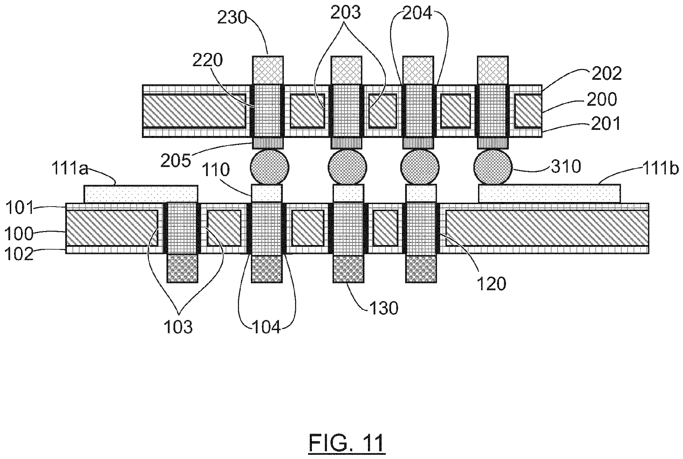

La **figure 11** montre une autre variante de l'invention qui associe les structures des premier et deuxième substrats comme décrit dans les figures 9 et 10. On notera que c'est cette dernière structure qui offre la plus grande section possible à la bobine. Comme précédemment, l'espace entre les deux substrats pourra optionnellement être rempli, comme représenté sur la figure 7, d'un matériau destiné à augmenter la valeur d'inductance de la bobine

On notera également qu'en utilisant les structures décrites dans les figures 10 et 11 il devient possible de réaliser des bobines au moyen d'un empilement de plus de deux substrats et donc une section de bobine encore plus grande. On se référera aux substrats intercalés décrits plus haut sur ce point.

Dans tous les cas, les substrats peuvent être assemblés et reliés, mécaniquement et électriquement, par l'intermédiaire de billes 310 comme décrit précédemment.

L'invention peut donc présenter différentes zones de formation des portions de spire (sur la première face, sur la deuxième face ou dans l'un ou l'autre des premier et deuxième substrats 100, 200) et/ou différentes réalisations de la liaison conductrice 310 avec ou sans substrats intercalés. Ces différentes configurations permettent une grande flexibilité dans la hauteur de la bobine.

## Revendications

1. Composant microélectronique comprenant une bobine pourvue d'au moins une spire électriquement conductrice comprenant une première portion de spire formée sur un premier substrat (100), et une deuxième portion de spire, une première extrémité de la première portion étant reliée électriquement à une première extrémité de la deuxième portion par une liaison conductrice (310), la bobine présentant un axe longitudinal (610), autour duquel la au moins une spire est formée, qui est perpendiculaire à une direction selon une épaisseur du premier substrat (100),
**caractérisé en ce que** la deuxième portion est formée sur un deuxième substrat (200) différent du premier substrat (100), une première face du premier substrat étant en regard d'une première face du deuxième substrat, la liaison conductrice (310) s'étendant au moins dans un espace interstitiel situé entre la première face du premier substrat (100) et la première face du deuxième substrat (200).

2. Composant selon la revendication précédente, dans lequel la première portion est formée sur la première face du premier substrat ou sur une deuxième face du premier substrat opposée à la première face et/ou la deuxième portion est formée sur la première face du deuxième substrat ou sur une deuxième face du deuxième substrat opposée à la première face.

3. Composant selon l'une des revendications précédentes, dans lequel la liaison conductrice (310) comprend une portion qui s'étend dans l'espace interstitiel et comprend une portion s'étendant dans au moins l'un des premier et deuxième substrats (100, 200), et de préférence dans lequel la portion de la liaison conductrice (310) s'étendant dans au moins l'un des premier et second substrats (100, 200) comprend au moins un via conducteur traversant ledit au moins l'un des premier et second substrats (100, 200).

4. Composant selon l'une des revendications précédentes, comprenant au moins un substrat intercalé entre le premier substrat (100) et le deuxième substrat (200), la liaison conductrice (310) comprenant une portion s'étendant au travers du au moins un substrat intercalé, et de préférence dans lequel portion de la liaison conductrice (310) s'étendant au travers du au moins un substrat intercalé comprend au moins un via conducteur traversant ledit au moins un substrat intercalé.

5. Composant selon l'une des revendications précédentes, dans lequel la liaison conductrice (310) est configurée pour produire un assemblage mécanique des première et deuxième portions.

6. Composant selon l'une des revendications précédentes, dans lequel la liaison conductrice (310) comprend au moins l'un parmi les éléments suivants : une couche électriquement conductrice, un micro-tube ou un micropillier électriquement conducteur, une bille électriquement conductrice, une pâte ou un film conducteur anisotrope.

7. Composant selon l'une des revendications précédentes, dans lequel la liaison conductrice (310) a une dimension non nulle, suivant la direction en épaisseur du premier substrat (100).

8. Composant selon l'une des revendications 1 à 7, dans lequel la liaison conductrice (310) comprend une zone en continuité électrique de la première extrémité de la première portion, une zone en continuité électrique de la première extrémité de la deuxième portion, lesdites zones étant assemblées, de préférence par collage direct avec ou sans thermocompression.

9. Composant selon l'une des revendications précédentes, comprenant un élément magnétique (700) placé dans l'espace interstitiel au moins dans une zone dudit espace située dans la au moins une spire.

10. Composant selon l'une des revendications précédentes, dans lequel au moins l'un parmi le premier et le deuxième substrats (100, 200) comporte une couche électriquement conductrice surmontée par une couche superficielle (101) diélectrique, ladite couche électriquement conductrice contenant une parmi la première ou la deuxième portions.

11. Composant selon l'une des revendications précédentes, dans lequel les matériaux des premier et deuxième substrats (100, 200), au niveau de leur première face, sont différents.

12. Composant selon l'une des revendications précédentes, dans lequel la bobine comprend une pluralité de spires, deux spires successives de la pluralité de spires étant reliées électriquement par une liaison conductrice (310) entre une deuxième extrémité d'une première portion d'une des deux spires successives et une deuxième extrémité d'une deuxième portion de l'autre des deux spires successives.

13. Système électronique comprenant au moins un composant microélectronique selon l'une des revendications précédentes, et de préférence comprenant une pluralité de composants microélectroniques ayant le même premier substrat (100) et des deuxièmes substrats différents.

14. Procédé de fabrication d'un composant microélectronique comprenant une bobine pourvue d'au moins une spire électriquement conductrice, comprenant :
- la formation d'une première portion de spire de la au moins une spire sur un premier substrat (100), et la formation d'une deuxième portion de spire de la au moins une spire, la bobine présentant un axe longitudinal (610), autour duquel la au moins une spire est formée, qui est perpendiculaire à une direction selon une épaisseur du premier substrat (100);
- le raccordement électrique d'une première extrémité de la première portion à une première extrémité de la deuxième portion par une liaison conductrice (310),
**caractérisé en ce que** la formation de la deuxième portion est réalisée sur un deuxième substrat (200) différent du premier substrat (100), une première face du premier substrat (100) étant placée en regard de d'une première face du deuxième substrat (200), la liaison conductrice (310) s'étendant au moins dans un espace interstitiel situé entre la face du premier substrat (100) et la face du deuxième substrat (200).

15. Procédé selon la revendication précédente, dans lequel la première portion est formée sur la première face du premier substrat ou sur une deuxième face du premier substrat opposée à la première face et/ou la deuxième portion est formée sur la première face du deuxième substrat ou sur une deuxième face du deuxième substrat opposée à la première face, et de préférence dans lequel on assemble mécaniquement les première et deuxième portions en même temps que le raccordement électrique, au moyen de la liaison conductrice (310).

16. Procédé selon la revendication précédente, dans lequel la liaison conductrice (310) est formée avec au moins l'un parmi les éléments conducteurs suivants: une couche électriquement conductrice, un micro-tube ou un micropillier électriquement conducteur, une bille électriquement conductrice, une pâte ou un film conducteur anisotrope, le procédé comprenant, sur au moins l'une parmi la première portion et la deuxième portion :
- le dépôt d'une couche diélectrique (410) ;
- la formation d'une ouverture dans la couche diélectrique, au droit de la première extrémité ;
- la formation de l'élément conducteur au contact de ladite une parmi la première portion et la deuxième portion, au travers de l'ouverture ;
et de préférence dans lequel la formation de l'élément conducteur comprend le dépôt d'une couche ou d'un ensemble de couches électriquement conductrices sur la ladite une parmi la première et la deuxième portions au travers de l'ouverture, et le dépôt d'une bille fusible sur la couche électriquement conductrice, cette couche ou ensemble de couches conductrices faisant également fonction de liaison mécanique.

17. Procédé selon la revendication précédente, comprenant une fusion de tout ou partie de l'élément conducteur pendant l'assemblage des portions.

18. Procédé selon l'une des revendications 14 à 17, dans lequel la liaison conductrice (310) est formée par collage direct avec ou sans thermocompression configuré pour assembler une zone en continuité électrique de la première extrémité de la première portion et une zone en continuité électrique de la première extrémité de la deuxième portion.
